Europäisches Patentamt

European Patent Office

Office européen des brevets

(11) Numéro de publication: **0 310 494**
**A2**

## (12) DEMANDE DE BREVET EUROPEEN

(21) Numéro de dépôt: 88402436.5

(22) Date de dépôt: 27.09.88

(51) Int. Cl.⁴: **C 30 B 15/20**
**C 30 B 15/28**

(30) Priorité: 29.09.87 FR 8713446

(43) Date de publication de la demande:
05.04.89 Bulletin 89/14

(84) Etats contractants désignés:
CH DE GB IT LI SE

(71) Demandeur: **COMMISSARIAT A L'ENERGIE ATOMIQUE**
**31/33, rue de la Fédération**
**F-75015 Paris (FR)**

(72) Inventeur: **Bertin, François**
**46, Avenue Marcellin Berthelot**
**F-38100 Grenoble (FR)**

**Chabli, Amal**
**1, rue de Docteur Calmette**
**F-38130 Echirolles (FR)**

(74) Mandataire: **Mongrédien, André et al**
**c/o BREVATOME 25, rue de Ponthieu**
**F-75008 Paris (FR)**

(54) **Procédé de commande d'une machine de tirage de monocristaux.**

(57) L'invention concerne un procédé de commande d'une machine de tirage de monocristaux.

Le procédé consiste notamment à enregistrer dans une mémoire d'un calculateur commandant la machine un programme de régulation des moyens de chauffage (3) d'un creuset (1) de la machine, contenant un bain (2) d'un produit fondu servant au tirage par une broche (7) munie d'un germe monocristallin (6). Le programme consiste essentiellement à calculer les rapports (dP/dL) des dérivées de poids aux dérivées de déplacement de broche à des instants prédéterminés, puis à comparer ces valeurs de rapports à des valeurs corrrespondantes de référence, pour obtenir une valeur numérique d'erreur pour chacun de ces rapports. Le procédé consiste ensuite à effectuer un traitement proportionnel, intégral et dérivée des valeurs numériques d'erreur, les résultats de ce traitement étant additionnés à des valeurs de référence de températures pour chaque déplacement de broche correspondante. Les résultats de ces additions constituent des valeurs numériques de commande de régulation appliquées à des moyens (4) de commande de régulation des moyens de chauffage (3).

Application au tirage de monocristaux.

FIG. 2

EP 0 310 494 A2

Bundesdruckerei Berlin

## Description

### PROCEDE DE COMMANDE D'UNE MACHINE DE TIRAGE DE MONOCRISTAUX

La présente invention concerne un procédé de commande d'une machine de tirage de monocristaux.

Ce procédé permet de tirer des monocristaux à partir d'un bain de produits fondus ; ces monocristaux sont essentiellement utilisés pour la fabrication de circuits intégrés. Ce procédé est mis en oeuvre par une machine de tirage dans laquelle le bain de produit fondu est contenu dans un creuset et est maintenu à une température supérieure au point de fusion du produit, par des moyens de chauffage appropriés. Le cristal massif ou lingot est obtenu par croissance autour d'un germe monocristallin du même produit, placé l'extrémité inférieure d'une broche de tirage d'axe vertical, selon une méthode dite de Czochralski, connue dans l'état de la technique et qui ne sera pas décrite ici en détail.

Les machines de tirage fonctionnant selon la méthode de Czochralski sont principalement utilisées dans la cristallisation de matériaux pour lesquels à l'état solide cristallisé, ces matériaux présentent la même composition qu'à l'état liquide. On dit alors que ces matériaux présentent une fusion congruente. C'est le cas, par exemple, de certains oxydes ainsi que des semiconducteurs du type silicium, germanium, arséniure de gallium,...

Dans les machines connues qui permettent d'effectuer des tirages de monocristaux selon la méthode de Czochralski, le germe monocristallin est amené au contact du bain liquide, dont la température est ajustée de façon qu'à l'interface solide-liquide, existent des conditions telles qu'à chaque instant, la quantité d'atomes cristallisés soit identique à la quantité d'atomes qui retournent en fusion. La croissance est obtenue en exerçant sur une broche de tirage, dont une extrémité permet de fixer le germe, un mouvement régulier de translation vertical à une vitesse généralement comprise entre 1 et 30 mm par heure. Pour contrôler la forme de l'interface solide-liquide, on superpose au mouvement de translation de la broche, un mouvement de rotation de celle-ci autour de son axe à une vitesse généralement comprise entre 0 et 100 tours par minute. Le déplacement vers le haut de l'interface solide-liquide amène cette interface dans une zone plus froide, ce qui a pour effet de faire cristalliser le bain sur le germe, et ainsi de faire croître le monocristal dans le but d'en former un lingot cylindrique de diamètre aussi constant que possible.

La nécessité d'obtenir des monocristaux de géométrie régulière a conduit les réalisateurs de machines à rechercher des procédés de commande aboutissant à la régularité du diamètre du monocristal au cours de son tirage. Cette régularité est généralement obtenue à partir des mesures du poids du monocristal en cours de tirage. A cet effet, un capteur de poids est généralement placé à une extrémité de la broche de tirage et transmet des signaux représentatifs des valeurs de poids à un ensemble de traitement et de commande ; ces moyens de traitement et de commande permettent de contrôler la translation et la rotation de la broche. Les machines connues ne sont pas entièrement automatiques, car les procédés qu'elles mettent en oeuvre n'utilisent pas des traitements adéquats des informations de poids au cours du tirage et des informations concernant la géométrie du cristal à obtenir. Il en résulte que la régulation des moyens de chauffage contenant le creuset, le tirage du monocristal après contact du germe avec le produit en fusion, puis le refroidissement du four à la fin du tirage, sont des opérations qui ne sont pas entièrement automatiques, qui sont effectuées de manière souvent empirique et dont les résultats sont par conséquent aléatoires, ce qui est un grave inconvénient car les monocristaux à obtenir sont des produits très coûteux.

Un procédé utilisant la méthode de Czochralski dans une machine de tirage, rendant ce tirage automatique et améliorant ainsi très nettement la qualité des monocristaux obtenus, est décrit dans la demande de brevet européen n° 0 142 415 publiée le 22 mai 1985. Dans cette demande de brevet, la régulation de la température des moyens de chauffage est effectuée en contrôlant la puissance électrique fournie à ces moyens de chauffage, à partir d'un traitement des signaux relatifs à la dérivée du poids du monocristal par rapport au temps. Ces traitements consistent notamment à appliquer aux signaux de dérivée de poids une action proportionnelle et intégrale. Les signaux ainsi obtenus fournissent une tension de consigne des moyens de chauffage.

Le procédé décrit dans la demande de brevet précitée, s'il permet bien d'automatiser une machine de tirage selon la méthode de Czochralski et de fournir des monocristaux de bonne qualité, a cependant pour inconvénient de ne pas faire intervenir le paramètre temps et donc la vitesse de tirage dans la régulation des moyens de chauffage ; en effet, comme indiqué plus haut, cette régulation fait intervenir les signaux de dérivée de poids par rapport au temps. Or, la vitesse de tirage est difficile à contrôler puisque notamment des variations de vitesse peuvent apparaître au cours du tirage, à cause des jeux mécaniques impossibles à maîtriser au cours de ce tirage. Ces variations de la vitesse de tirage provoquent des variations du diamètre du monocristal tiré.

De plus, dans le tirage de certains monocristaux, il est nécessaire, pour éviter l'évaporation du bain, de mettre un "encapsulant" liquide à la surface du bain dans le creuset. Cet encapsulant produit une poussée d'Archimède sur le lingot de monocristal, au cours du tirage. Avec la machine décrite dans le brevet précité, on ne tient pas compte de cette poussée qui est cependant un paramètre très important puisque la poussée d'Archimède produit un allègement du lingot et modifie ainsi le poids mesuré, selon le niveau de l'encapsulant dans le creuset, au cours du tirage.

L'invention a précisément pour but de remédier à ces inconvénients grâce à un procédé dans lequel la régulation des moyens de chauffage est complètement indépendante de la vitesse de tirage. Ces buts sont atteints, comme on le verra plus loin en détail, notamment en utilisant pour la régulation des moyens de chauffage, des signaux résultant du traitement de signaux de dérivées de poids par rapport aux variations de déplacement de broche et non pas par rapport au temps. L'utilisation de tels signaux permet également de tenir compte des effets de la poussée d'Archimède à laquelle est soumise le lingot, lorsque le bain de produit fondu est recouvert d'un liquide encapsulant. On obtient ainsi une régulation précise ou un contrôle précis du diamètre du monocristal tiré.

L'invention concerne un procédé de commande d'une machine de tirage de monocristaux, cette machine comprenant un creuset contenant un bain d'un produit fondu et stabilisé à une température supérieure au point de fusion du produit par des moyens de chauffage, de commande de régulation de température de ces moyens de chauffage, ce produit étant éventuellement recouvert d'un encapsulant, le tirage étant effectué à l'aide d'un germe monocristallin du produit placé à l'extrémité inférieure d'une broche de tirage d'axe vertical, la machine comprenant aussi un bâti fixe, un chariot mobile en translation par rapport au bâti parallèlement à l'axe propre de la broche de tirage, des moyens pour commander la translation du chariot et du creuset parallèlement à l'axe de la broche, le chariot supportant la broche de tirage, et des moyens pour commander la rotation du chariot et de la broche autour de son axe propre, le procédé consistant à enregistrer dans la mémoire d'un calculateur des paramètres relatifs à la géométrie du monocristal et à sa croissance, ainsi qu'un programme de traitement de ces paramètres pour que le calculateur commande, par des signaux appliqués aux moyens de commande, la translation et la rotation du chariot et du creuset, et à enregistrer un programme de régulation pour que le calculateur commande la régulation des moyens de chauffage par des valeurs numériques de commande de régulation appliquées aux moyens de commande de régulation, caractérisé en ce que le programme de régulation consiste à échantillonner et à commander l'enregistrement à des instants prédéterminés, au cours du tirage, des valeurs numériques de dérivées de poids par rapport au temps, obtenues à partir de valeurs numériques fournies par des moyens de mesure de poids relatives à l'évolution du poids, du germe, du monocristal et éventuellement de l'encapsulant au cours du tirage, et à enregistrer aux instants prédéterminés au cours du tirage des valeurs numériques de dérivées de déplacement de broche par rapport au temps, obtenues à partir de moyens de mesure fournissant des valeurs numériques de positions de broche et de creuset par rapport à une position de référence, le programme consistant ensuite à calculer les rapports des dérivées de poids aux dérivées de déplacement de broche aux instants prédéterminés, puis à comparer ces valeurs de rapports à des valeurs corrrespondantes de référence, pour obtenir une valeur numérique d'erreur pour chacun de ces rapports, le procédé consistant ensuite à effectuer un traitement proportionnel, intégral et dérivée des valeurs numériques d'erreur, les résultats de ce traitement étant additionnés à des valeurs de référence de températures pour chaque déplacement de broche correspondant, les résultats de ces additions constituant les valeurs numériques de commande de régulation appliquées aux moyens de commande de régulation auxquels on fournit aussi, aux instants prédéterminés correspondants, des valeurs numériques des températures fournies par des moyens de mesure de températures, les instants prédéterminés étant séparés par des intervalles de temps successifs égaux.

Selon une autre caractéristique de l'invention, on utilise un filtre numérique programmable de type passe-bas pour filtrer lesdites valeurs numériques de déplacement de broche préalablement au calcul et à l'enregistrement des dérivées de déplacement de broche par rapport au temps, échantillonnées et enregistrées, le programme correspondant à ce filtre numérique étant contenu dans la mémoire du calculateur, ce filtre éliminant les variations des valeurs numériques correspondant à des fluctuations de déplacements de broches supérieures à une fréquence de coupure prédéterminée.

Selon une autre caractéristique, pour obtenir les valeurs numériques représentatives de l'évolution du poids, on effectue à l'aide d'un capteur de poids fournissant un signal analogique, une mesure du poids de la broche, du germe, du monocristal et éventuellement de l'encapsulant au cours du tirage, puis un filtrage analogique du signal de mesure appliqué à un filtre de type passe-bas, puis une soustraction à l'aide d'un soustracteur du signal filtré de mesure et d'un signal analogique représentatif du poids de la broche, le signal résultant de cette soustraction étant converti en valeurs numériques dans un convertisseur analogique-numérique, ces valeurs numériques étant fournies au calculateur pour le calcul, l'échantillonnage et l'enregistrement desdites dérivées de poids.

Selon une autre caractéristique, les valeurs numériques de commande de régulation et les valeurs numériques de températures mesurées sont appliquées à un soustracteur des moyens de régulation, un signal numérique de sortie de ce soustracteur étant appliqué à un régulateur numérique de ces moyens de régulation, ce régulateur fournissant un signal de commande des moyens de chauffage.

Les caractéristiques et avantages de l'invention ressortiront mieux de la description qui va suivre, donnée en référence aux dessins annexés dans lesquels :

    - la figure 1 représente schématiquement un lingot de monocristal en cours de tirage, notamment en présence d'un liquide encapsulant le bain de produits fondus dans le creuset,

    - la figure 2 représente schématiquement une machine de tirage mettant en oeuvre le procédé de l'invention,

    - la figure 3 est un organigramme du procédé de l'invention.

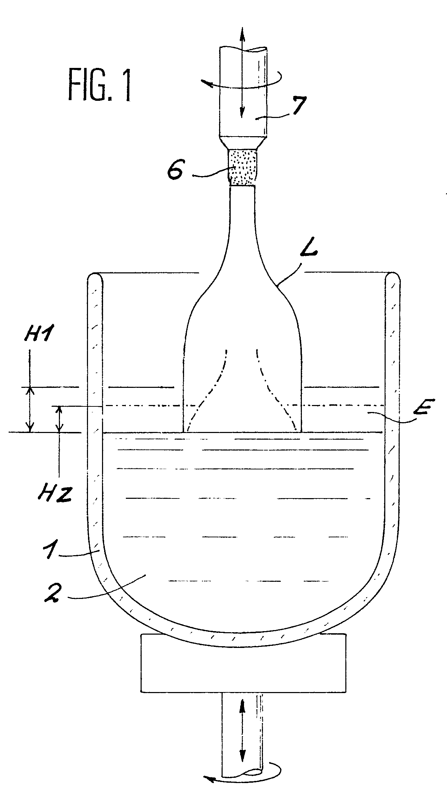

La figure 1 représente schématiquement un lingot L de monocristal, en cours de tirage à partir d'un bain 2 de produits fondus, contenu dans un creuset 1 ; de manière connue, le creuset 1, peut être entraîné en rotation et en translation, tandis que le lingot 1 est entraîné lui aussi en rotation et en translation, par une broche de tirage 7, à l'extrémité de laquelle est fixé, de manière connue, un germe monocristallin 6. Lorsque le bain de produits fondus 2 est volatil, on place à la surface du bain, un liquide encapsulant E qui évite l'évaporation du bain au cours du tirage. Comme on le verra plus loin en détail, un capteur de poids, couplé à la broche de tirage 7, permet de mesurer le poids du lingot et de la broche au cours du tirage. En présence d'un liquide encapsulant E, le poids mesuré n'est pas en fait le poids réel puisque la poussée d'Archimède exercée sur le lingot L par l'encapsulant E dépend de la hauteur (H1, H2) de l'encapsulant, qui varie au-dessus du niveau du bain au cours de la croissance. Cette poussée est en effet proportionnelle au poids du volume du liquide déplacé par la partie du lingot immergée dans l'encapsulant. Bien entendu, le creuset est situé dans une enceinte chauffée qui n'est pas représentée sur cette figure et qui ne sera pas décrite.

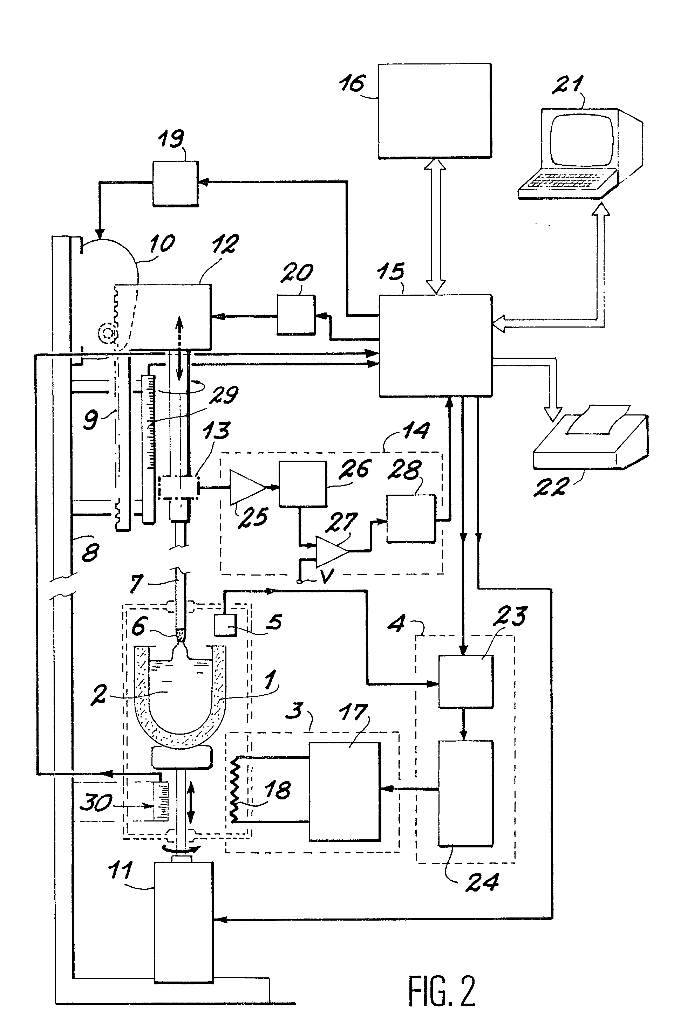

La figure 2 représente schématiquement un dispositif permettant de mettre en oeuvre le procédé de l'invention.

Ce dispositif permet le tirage d'un monocristal et comprend un creuset 1 contenant un bain d'un produit fondu 2 stabilisé à une température supérieure au point de fusion de ce produit, grâce à des moyens de chauffage 3, de régulation 4, et de mesure 5 de températures des moyens de chauffage.

Les moyens 5 de mesure de températures ne sont pas représentés ici en détail et peuvent être constitués par exemple par une sonde reliée à un convertisseur analogique numérique qui fournit sur une sortie la valeur numérique de la température de l'enceinte contenant le creuset 1.

Les moyens de chauffage 3 peuvent être constitués par exemple par une source électrique 17 de courant continu, alimentant une résistance 18. Cette alimentation comporte une entrée de commande analogique permettant de régler la valeur de l'intensité du courant circulant dans la résistance 18, de manière à réguler la température dans l'enceinte contenant le creuset.

Le tirage est effectué de manière connue à l'aide d'un germe monocristallin 6 du produit, placé à l'extrémité inférieure d'une broche 7 de tirage, d'axe vertical.

La machine comporte aussi un bâti fixe 8, un chariot 9 mobile en translation par rapport au bâti 8 ; le déplacement du chariot est commandé par exemple par un moteur couple 10. Ce chariot se déplace parallèlement à l'axe propre de la broche de tirage 7 et il supporte cette broche ainsi que des moyens 12, constitués par exemple par un moteur couple, permettant d'entraîner la broche en rotation autour de son axe.

Le dispositif comprend aussi des moyens 11 pour déplacer le creuset 1 en translation et en rotation (comparables aux moyens 9, 10, 12) ; le déplacement de translation s'effectue parallèlement à l'axe de la broche.

Les moteurs 10, 12 sont respectivement commandés par les ensembles de commande 19, 20 qui ne sont pas décrits ici en détail et qui reçoivent des ordres de commande provenant d'un calculateur 15, dont le rôle sera expliqué plus loin. Les moyens 11 de déplacement du creuset sont eux aussi commandés par des ordres reçus du calculateur 15.

Le dispositif comporte aussi une mémoire 16 reliée au calculateur 15. Cette mémoire permet d'enregistrer, selon le procédé de l'invention, des paramètres relatifs à la géométrie du monocristal et à sa croissance, ainsi qu'un programme de traitement de ces paramètres, pour que le calculateur commande par des signaux appliqués aux moyens de commande 10, 11, 12 la translation du chariot et du creuset, ainsi que leur rotation. Ce programme connu dans l'état de la technique ne sera pas ici décrit en détail puisqu'il ne constitue pas l'objet de l'invention.

Le calculateur 15 peut être bien entendu relié, de façon connue, à un terminal à clavier et à écran 21, ainsi qu'à une imprimante 22.

La mémoire 16 du calculateur 15 permet aussi d'enregistrer un programme de régulation qui sera décrit plus loin en détail, pour que le calculateur commande la régulation des moyens de chauffage 3 du bain fondu, par des valeurs numériques de commande de régulation appliquées à des moyens de commande de régulation 4, par le calculateur 5.

Le dispositif comporte aussi des moyens 29, 30 de mesures respectives de positions de la broche 7 et du creuset 1 au cours du tirage, par rapport à une position de référence. Ces moyens ne sont pas représentés en détail sur la figure. Ils peuvent être respectivement constitués par des capteurs optiques de position associés à des codeurs numériques. Les différences de positions de la broche et du creuset, mesurées successivement au cours du tirage, depuis le début de celui-ci, représentent en fait les longueurs du monocristal qui se forme progressivement. Dans la suite de l'exposé, la dénomination "déplacement de broche" correspond en fait à la longueur du monocristal formé. Les déplacements de translation de la broche 7 et du creuset 1 sont en fait commandés de sorte que le niveau du bain fondu dans le creuset, par rapport à la position de référence, soit constant.

Les moyens 4 de commande de régulation de températures comportent notamment un soustracteur 23 dont une entrée reçoit les valeurs numériques de commande de régulation fournies par le calculateur 15 et dont une autre entrée reçoit des valeurs numériques fournies par les moyens de mesure de températures 5 dans l'enceinte contenant le creuset 1.

Les moyens de commande de régulation 4 comportent aussi un régulateur numérique de température 24 dont une entrée est reliée à une sortie du soustracteur 23. Cette entrée du régulateur reçoit, comme on le verra plus loin en détail, des valeurs numériques permettant au régulateur de commander le réglage de la source électrique 17, pour réguler la puissance électrique fournie par cette source à la résistance 18 et, par conséquent, pour réguler la température dans l'enceinte.

Le dispositif comprend aussi un capteur de poids 13 constitué de façon connue, solidaire de la broche de tirage 7. Ce capteur fournit un signal analogique représentatif du poids de la broche 7, du germe 6 et du monocristal, au cours du tirage.

Le signal de sortie du capteur 13 est appliqué à des moyens numériques 14 de mesure de poids. Ces moyens numériques comportent notamment un amplificateur 25 dont la sortie est reliée à un filtre analogique 26 de type passe-bas. La sortie de ce filtre est reliée à une entrée d'un soustracteur 27 dont une autre entrée reçoit un signal analogique V provenant d'une source de tension par exemple (non représentée sur la figure), ce signal étant représentatif du poids de la broche de tirage à vide. Ainsi, à la sortie du soustracteur 27 le signal analogique fourni est un signal représentatif du poids du germe du monocristal et éventuellement de l'encapsulant, au cours du tirage, puisque le poids de la broche a été éliminé par le soustracteur. Ce signal est appliqué à un convertisseur analogique-numérique 28 dont la sortie est reliée au calculateur 15.

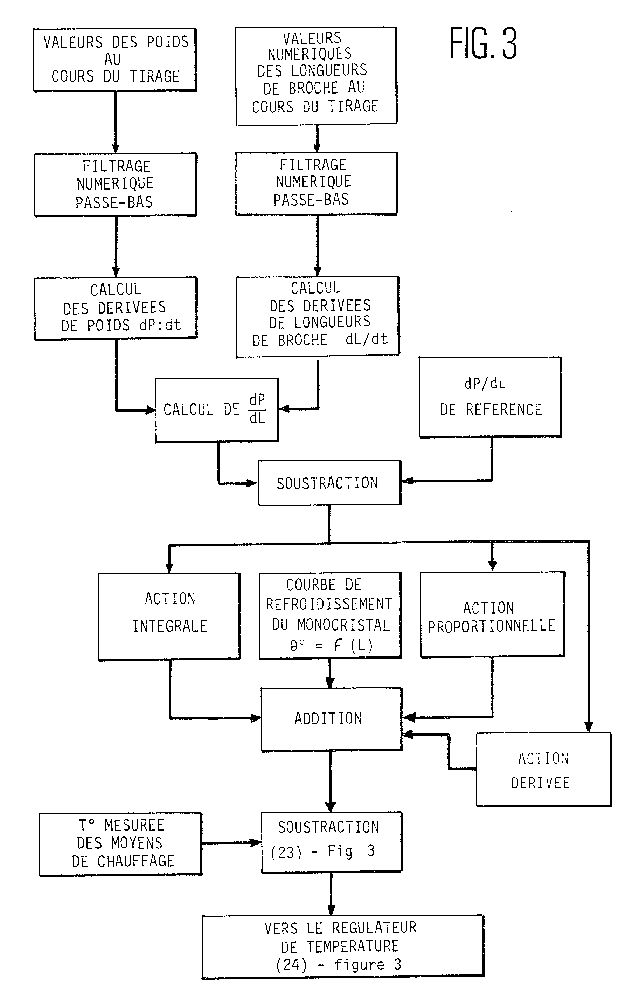

La figure 3 est un organigramme qui permet de mieux comprendre le procédé de commande de l'invention, et notamment le déroulement du programme de régulation de température.

Les valeurs numériques représentatives du poids du germe et du monocristal au cours du tirage, fournies par le convertisseur analogique-numérique 28 et acquises par le calculateur 15, sont soumises, de façon connue, par le calculateur 15 à un filtrage numérique de type passe-bas. Ces valeurs numériques sont échantillonnées par le calculateur, à des instants prédéterminés au cours du tirage ; ces instants prédéterminés sont séparés par des intervalles de temps successifs égaux ; le calculateur commande l'enregistrement dans sa mémoire, de valeurs numériques correspondant à des dérivées de poids dP/dt par rapport au temps, obtenues à partir des valeurs fournies par le convertisseur 28 et échantillonnées comme indiqué plus haut. Le filtrage de type passa-bas élimine des valeurs de poids mesurées, celles dont les fluctuations sont supérieures à une fréquence de coupure prédéterminée.

De la même manière, les valeurs numériques des positions de la broche et du creuset, par rapport à une position de référence, fournies par les moyens 29, 30 et qualifiées de déplacement de broche, sont échantillonnées aux instants prédéterminés et filtrées par le calculateur ; le calculateur applique à ces valeurs numériques un filtrage numérique de type passe-bas. Ce filtrage numérique est obtenu grâce à un programme contenu dans la mémoire 16 du calculateur 15. Il élimine les valeurs numériques correspondant à des longueurs de broche présentant des fluctuations supérieures à une fréquence de coupure prédéterminée. Ce type de filtrage est décrit dans la demande de brevet N° EN 87 10216 déposée le 20/07/87 au nom du même demandeur.

Les valeurs numériques de position, ainsi filtrées, sont utilisées par le calculateur pour calculer les dérivées correspondantes dL/dt de déplacements de broche par rapport au temps. Les valeurs numériques de ces dérivées sont enregistrées dans la mémoire 16 du calculateur 15. En fait une mesure, au cours du tirage, les variations de déplacements de broche, au cours d'intervalles de temps successifs égaux.

Selon l'invention, on calcule ensuite les rapports des dérivées de poids dP/dt aux dérivées des déplacements de broche dL/dt aux instants d'échantillonnage prédéterminés, de manière à obtenir des valeurs numériques dP/dL correspondant aux dérivées de poids par rapport aux dérivées de déplacements de broche.

On compare alors les valeurs numériques dP/dL à des valeurs numériques correspondantes de référence dP/dL, obtenues par calcul, pour une forme idéalisée du lingot de monocristal que l'on souhaite obtenir. On commande ainsi la régulation précise ou le contrôle précis du diamètre du monocristal tiré.

Cette comparaison fournit une valeur numérique d'erreur pour chacun de ces rapports dP/dL. Le procédé consiste ensuite à effectuer un traitement ou action proportionnelle, intégrale et dérivée de ces valeurs numériques d'erreur. Ce traitement mathématique qui est ici effectué sur les valeurs numériques d'erreur des rapports dP/dL, n'est pas décrit en détail car il est connu dans l'état de la technique.

Les résultats des traitements des valeurs numériques d'erreur sont ensuite additionnés à des valeurs de référence de températures, données par une courbe de refroidissement du monocristal $\theta° = f(L)$. Cette courbe représente la température de ce monocristal (en fait la température dans l'enceinte contenant le creuset) pour chacun des déplacements de broche, et donc pour chacune des longueurs du monocristal formé. Les résultats de ces additions constituent les valeurs numériques de commande de régulation ; ces valeurs sont appliquées au moyen 4 de commande de régulation et notamment au soustracteur 23 de ces moyens de commande qui reçoivent d'autre part des valeurs numériques de températures des moyens de chauffage. Les valeurs numériques résultant de la soustraction sont appliquées au régulateur de température 24 des moyens de régulation 4.

Dans le procédé qui vient d'être décrit, la régulation du diamètre des monocristaux, qui est obtenue à partir de traitements de valeurs numériques correspondant aux dérivées de poids par rapport aux déplacements de broches (dP/dL) est indépendante de la vitesse de tirage dL/dt. Il en résulte que cette régulation de diamètre est très rigoureuse puisqu'elle n'est plus soumise à des fluctuations possibles de vitesse de tirage, dues par exemple aux imperfections des organes mécaniques de la machine. En outre, cette régulation du diamètre reste valable même lorsque la vitesse de tirage du monocristal est volontairement modifiée.

Le procédé qui vient d'être décrit pour le tirage d'un monocristal, à partir d'un bain de produits non volatils en fusion peut aussi être appliqué au tirage de monocristaux pour lesquels les produits en fusion sont volatils. Dans ce cas, il suffit de recouvrir le bain en fusion par un produit encapsulant non volatil. Ce produit est chimiquement inactif avec les éléments constitutifs du bain et présente une densité inférieure à celle de celui-ci. En fait, grâce au procédé de l'invention, la régulation permet de transformer les variations de poids, en variations de température.

**Revendications**

1. Procédé de commande d'une machine de tirage de monocristaux, cette machine comprenant un creuset (1) contenant un bain d'un produit fondu (2) et stabilisé à une température supérieure au point de fusion du produit par des moyens de chauffage (3), de commande de régulation (4) de température de ces moyens de chauffage, ce produit étant éventuellement recouvert d'un encapsulant, le tirage étant effectué à l'aide d'un germe monocristallin (6) du produit placé à l'extrémité inférieure d'une broche (7) de tirage d'axe vertical, la machine comprenant aussi un bâti fixe (8), un chariot (9) mobile en translation par rapport au bâti (8) parallèlement à l'axe propre de la broche de tirage (7), des moyens (10, 11) pour commander la translation du chariot et du creuset (1) parallèlement à l'axe de la broche (7), le chariot (9) supportant la broche de tirage, et des moyens (11, 12) pour commander la rotation du chariot et de la broche autour de son axe propre, le procédé consistant à enregistrer dans la mémoire d'un calculateur des paramètres relatifs à la géométrie du monocristal et à sa croissance, ainsi qu'un programme de traitement de ces paramètres pour que le calculateur commande, par des signaux appliqués aux moyens de commande (10, 11, 12), la translation et la rotation du chariot et du creuset, et à enregistrer un programme de régulation pour que le calculateur commande la régulation des moyens de chauffage (3) par des valeurs numériques de commande de régulation appliquées aux moyens (4) de commande de régulation, caractérisé en ce que le programme de régulation consiste à échantillonner et à commander l'enregistrement à des instants prédéterminés, au cours du tirage, des valeurs numériques de dérivées de poids par rapport au temps, obtenues à partir de valeurs numériques fournies par des moyens (13, 14) de mesure de poids relatives à l'évolution du poids du germe, du monocristal et éventuellement de l'encapsulant, au cours du tirage, et à enregistrer aux instants prédéterminés au cours du tirage des valeurs numériques de dérivées de déplacement de broche par rapport au temps, obtenues à partir de moyens de mesure (29) fournissant des valeurs numériques de positions et de creuset de broche par rapport à une position de référence, le programme consistant ensuite à calculer les rapports (dP/dL) des dérivées de poids aux dérivées de déplacement de broche aux instants prédéterminés, puis à comparer ces valeurs de rapports à des valeurs corrrespondantes de référence, pour obtenir une valeur numérique d'erreur pour chacun de ces rapports, le procédé consistant ensuite à effectuer un traitement proportionnel, intégral et dérivée des valeurs numériques d'erreur, les résultats de ce traitement étant additionnés à des valeurs de référence de températures pour chaque déplacement de broche correspondante, les résultats de ces additions constituant les valeurs numériques de commande de régulation appliquées aux moyens (4) de commande de régulation auxquels on fournit aussi, aux instants prédéterminés correspondants, des valeurs numériques des températures fournies par des moyens (5) de mesure de températures, les instants prédéterminés étant séparés par des intervalles de temps successifs égaux.

2. Procédé selon la revendication 1, caractérisé en ce qu'on utilise un filtre numérique programmable de type passe-bas pour filtrer lesdites valeurs numériques de déplacement de broche préalablement à l'échantillonnage, au calcul et à l'enregistrement des dérivées de longueur de broche par rapport au temps, échantillonnées et enregistrées, le programme correspondant à ce filtre numérique étant contenu dans la mémoire du calculateur (15), ce filtre éliminant les variations des valeurs numériques correspondant à des déplacements de broche dont les fluctuations sont supérieures à une fréquence de coupure prédéterminée.

3. Procédé selon la revendication 2, caractérisé en ce que pour obtenir les valeurs numériques représentatives de l'évolution du poids, on effectue à l'aide d'un capteur de poids (13) fournissant un signal analogique, une mesure du poids de la broche, du germe, du monocristal et éventuellement de l'encapsulant, au cours du tirage, puis un filtrage analogique du signal de mesure appliqué à un filtre de type passe-bas (26), puis une soustraction à l'aide d'un soustracteur (28) du signal filtré de mesure et d'un signal analogique représentatif du poids de la broche, le signal résultant de cette soustraction étant converti en valeurs numériques dans un convertisseur analogique-numérique (28), ces valeurs numériques étant fournies au calculateur (15) pour le calcul, l'échantillonnage et l'enregistrement desdites dérivées de poids.

4. Procédé selon la revendication 3, caractérisé en ce que les valeurs numériques de commande de régulation et les valeurs numériques de températures mesurées sont appliquées à un soustracteur (23) des moyens de régulation (4), un signal numérique de sortie de ce soustracteur étant appliqué à un régulateur numérique (24) de ces moyens de régulation, ce régulateur fournissant un signal de commande des moyens de chauffage (3).

FIG. 1

FIG. 2

# FIG. 3

VALEURS DES POIDS AU COURS DU TIRAGE

VALEURS NUMERIQUES DES LONGUEURS DE BROCHE AU COURS DU TIRAGE

FILTRAGE NUMERIQUE PASSE-BAS

FILTRAGE NUMERIQUE PASSE-BAS

CALCUL DES DERIVEES DE POIDS dP:dt

CALCUL DES DERIVEES DE LONGUEURS DE BROCHE  dL/dt

CALCUL DE $\frac{dP}{dL}$

dP/dL DE REFERENCE

SOUSTRACTION

ACTION INTEGRALE

COURBE DE REFROIDISSEMENT DU MONOCRISTAL $\theta° = f(L)$

ACTION PROPORTIONNELLE

ADDITION

ACTION DERIVEE

T° MESUREE DES MOYENS DE CHAUFFAGE

SOUSTRACTION (23) - Fig 3

VERS LE REGULATEUR DE TEMPERATURE (24) - figure 3